# EUROPEAN PATENT SPECIFICATION

(11) **EP 0 662 705 B1**
(45) Date of publication and mention of the grant of the patent: **23.08.2000**
(21) Application number: 94120888.6
(22) Date of filing: 29.12.1994
(51) Int. Cl.: H01L 21/321, H01L 21/306

(54) **Cleaning agent for semiconductor device and method for manufacturing semiconductor device**
Reinigungsmittel für Halbleiter-Anordnung und Verfahren zur Herstellung einer Halbleiter-Anordnung
Agent de nettoyage pour composant semi-conducteur et procédé de fabrication d'un composant semi-conducteur

(30) Priority: 07.01.1994 JP 52094
(43) Date of publication of application: 12.07.1995
(73) Proprietor: MITSUBISHI GAS CHEMICAL COMPANY, INC., Chiyoda-ku, Tokyo (JP)
(72) Inventor: Aoyama, Tetsuo, c/o Mitsubishi Gas Chem. Co. Inc., Niigata-shi, Niigata-ken (JP); Nakano, Rieko, c/o Mitsubishi Gas Chem. Co. Inc., Niigata-shi, Niigata-ken (JP); Fukuda, Hideki, c/o Mitsubishi Gas Chem. Co. Inc., Niigata-shi, Niigata-ken (JP); Goto, Hideo, c/o Texas Instruments Japan Ltd., Inashiki-gun, Ibaraki-ken (JP)
(74) Representative: Gille Hrabal Struck Neidlein Prop Roos

(56) References cited:
- EP-A- 0 463 423
- EP-A- 0 496 229
- US-A- 4 215 005
- US-A- 4 343 677
- US-A- 4 744 834
- PATENT ABSTRACTS OF JAPAN vol. 12 no. 357 (E-662) ,26 September 1988 & JP-A-63 114128 (SHOWA DENKO) 19 May 1988,
- PATENT ABSTRACTS OF JAPAN vol. 16 no. 295 (C-0957) ,30 June 1992 & JP-A-04 080297 (PIYURETSUKUSU) 13 March 1992,

## Description

### BACKGROUND OF THE INVENTION

### 1. Field of the Invention

The present invention concerns a cleaning agent for peeling a protecting deposition film to be used in a process for manufacturing a semiconductor device and a method of manufacturing a semiconductor device.

### 2. Description of the Related Arts

In the process for manufacturing a semiconductor device, an etching fabrication technology utilizing chemical reaction has been used as a method of forming a wiring structure on a semiconductor substrate by using a conductive material.

Generally, a method of at first applying a mask fabrication technology by photoresist and then removing a non-masked portion by using a chemical or a reactive gas has been conducted.

EP-A-0 496 229 teaches the use of wet-chemical etching solutions comprising hydrogen fluoride in combination with quaternary nitrogen compounds, one of the side chains of which consisting of 6 to 18 carbon atoms.

In recent semiconductor industries intending for high integration degree, fabrication for microscopic processing is required. In particular, a fabrication of metal film wirings has been demanded more and more and a fabrication technique aimed for accuracy of within 0.5 µm has been demanded for semiconductor device at present.

In order to attain the purpose, it is demanded to improve the fabrication accuracy of the photoresist and also improve the dry etching technique for removing the non-masked portion. Referring particularly to the photoresist, there are used not only conventional single-layer resist of positive or negative type but also multilayer resist using a combination of such resist and other resin.

Further, in the dry etching technique, anisotropic etching has been advanced with the establishment of a technique for side wall Protecting deposition films by using the photoresist and reactive gases, whereby more advanced selective etching has been carried out.

As a disadvantage accompanying the establishment of such techniques, there are mentioned an extreme difficulty in the method of removing the side wall protective deposition films, and corrosion of metal wiring materials. If the side wall protecting deposition film has not been removed sufficiently, radicals or ions in the reaction gas incorporated into the side wall protecting deposition film react with absorbed moisture to form an acid when left in the air after the completion of etching. The resultant acid corrodes wiring materials to bring about a significant adverse effect such as an increase in resistance and wire disconnection. Such a phenomenon frequently occurs, in particular, in aluminum and aluminum alloys used generally as the wiring material.

For preventing such corrosion, there has been adopted a method wherein chlorine radicals or ions are washed away by performing ultrapure-water cleaning for a long period of time after dry etching. However, it is extremely difficult to completely remove chlorine ions or radicals from the side wall protective deposition film by this method, so that a danger of causing corrosion can not completely be eliminated. Accordingly, it is indispensable to completely remove the side wall protecting deposition film in order to thoroughly prevent the corrosion.

For removing such a side wall protecting deposition film, a resist cleaning agent composed of an acidic organic solvent or of an alkaline organic solvent has been used.

As the resist cleaning agent composed of the acidic organic solvent, there is generally used a cleaning agent prepared by adding a phenolic compound, chloro-solvent or an aromatic hydrocarbon to alkylbenzenesulfonic acid. However, the use of this cleaning agent can not completely remove the side wall protecting deposition film even with a heat treatment at a temperature of 100°C or higher. Further, since the resist cleaning agent composed of the acidic organic solvent is less soluble in water, it is necessary to clean with an organic solvent compatible with water such as isopropanol after the removing operation and then wash with water, which however complicates the process.

On the other hand, it is also considerably difficult to remove the side wall protecting deposition film by using the resist cleaning agent composed of the alkaline organic solvent even by heating to a temperature of 100°C or higher as is the case with the acidic cleaning solution. As described above, since the side wall protecting deposition film cannot completely be removed by using either the acidic or alkaline cleaning agent, the occurrence of corrosion caused by residual chlorine radicals or ions is inevitable.

As a method different from the cleaning method described above, there has been known a method of removing the residual resist after plasma ashing by using an alkaline aqueous solution such as a positive type resist developing solution containing tetramethylammonium hydroxide (Japanese Patent Application Laid-Open No. Sho 62(1987)-281332). In this method, however, a conductive layer made of an aluminum-containing substrate is violently corroded by the alkaline aqueous solution.

EP-A-0 463 423 discloses a surface treating agent comprising an aqueous solution of a quaternary ammonium hydroxide.

Further, for the protecting deposition film formed upon dry etching of a titanium or tungsten layer, a method of removing the film has not yet been established. The titanium or tungsten layer is frequently used as metal wirings for an intermediate layer upon making a conductive layer into a multilayer structure in a semiconductor device.

If the resultant side wall protecting deposition film is left as it is, adjacent wirings are brought into contact with the side wall protecting deposition film, for example, owing to the pressure of the deposition film in the succeeding step to cause short-circuit or abnormality in wirings.

As described above, while various methods have been employed in a production process of a semiconductor device for removing the side wall protecting deposition film formed on the side walls of the conductive layer or photoresist formed on the semiconductor substrate, there are such problems as the occurrence of corrosion. Thus, it has been required to develop a cleaning agent for a semiconductor device capable of easily removing the side wall protecting deposition film and preventing corrosion to the metal conductive layer upon cleaning.

An object of the present invention is to overcome the foregoing problems and provide a cleaning agent for a semiconductor device capable of easily removing a side wall protecting deposition film formed by dry etching, and preventing corrosion to a conductive layer made of various kinds of metallic materials as the wiring material without causing any corrosion at all to any part, as well as a method of manufacturing a semiconductor device capable of manufacturing circuit wirings with high accuracy.

### SUMMARY OF THE INVENTION

As a result of an earnest study for solving the foregoing subject, the present inventors have found that a cleaning agent for peeling a protecting deposition film in a process to manufacture a semiconductor comprising an aqueous solution containing a quaternary ammonium salt and a fluoro-compound or an aqueous solution containing a quaternary ammonium salt, a fluoro-compound and an organic solvent selected from the group consisting of amides, lactones, nitriles, alcohols and esters exhibits excellent characteristics including removability for a side wall protecting deposition film formed upon dryetching, corrosion inhibition, non-corrosivity to wiring materials and good workability. The present invention has been accomplished on the basis of the aforesaid finding.

According to the present invention, there is provided a cleaning agent as defined in claim 1 and a method of cleaning as defined in claim 5.

Specifically, the present invention provides a cleaning agent for a semiconductor device which comprises a quaternary ammonium salt represented by the general formula:

[(R₁)₃N-R]⁺ · X⁻

in which R represents an alkyl group of 1 to 4 carbon atoms or a hydroxyl-substituted alkyl group of 1 to 4 carbon atoms, R₁ represents an alkyl group of 1 to 4 carbon atoms and X represents an organic acid group or inorganic acid group; and a fluoro-compound.

The present invention further provide a cleaning agent for a semiconductor device which comprises the above-mentioned quaternary ammonium salt and at least one organic solvent selected from the group consisting of amides, lactones, nitriles, alcohols and esters; and the fluoro-compound.

The present invention still further provides a method of manufacturing a semiconductor device by forming a mask with a photoresist on a conductive layer formed on a semiconductor substrate and containing at least one of titanium, tungsten, aluminum and an aluminum alloy and then forming a wiring structure by dry etching which method comprises a cleaning step of peeling a protecting deposition film formed on side walls of the conductive layer and the photoresist by using a cleaning agent for a semiconductor device comprising a quaternary ammonium salt represented by the general formula:

[(R₁)₃N-R]⁺ · X⁻

in which R represents an alkyl group of 1 to 4 carbon atoms or a hydroxyl substituted alkyl group of 1 to 4 carbon atoms, R₁ represents an alkyl group of 1 to 4 carbon atoms and X represents an organic acid group or inorganic acid group; and a fluoro-compound.

### BRIEF DESCRIPTION OF THE DRAWINGS

Fig. 1 is a cross sectional view showing a structure of a semiconductor device immediately after forming the conductive layer in Example 1.
Fig. 2 is a cross sectional view showing a structure upon completion up as far as the mask forming step in Example 1.
Fig. 3 is a cross sectional view showing a structure after removing a region of a conductive layer in Example 1 not covered with a photo-mask (non-masked region) by means of dry etching.
Fig. 4 is a cross sectional view showing a structure after removing masking resist by ashing followed by cleaning with a organic solvent after dry etching in Example 1.
Fig. 5 is a cross sectional view showing a structure after cleaning the semiconductor device shown in Fig. 4 by using the cleaning agent for the semiconductor device according to the present invention in Example 1.
Fig. 6 is a cross sectional view showing a structure of a semiconductor device immediately after forming the conductive layer in Example 4.
Fig. 7 is a cross sectional view showing a structure upon completing up as far as the mask forming step in Example 4.
Fig. 8 is a cross sectional view showing a structure after removing a region of a conductive layer in Example 4 not covered with a photo-mask (non-masked region) by means of dry etching.
Fig. 9 is a cross sectional view showing a structure after removing a masking resist by ashing followed by cleaning with an organic solvent after dry etching in Example 4.

Fig. 10 is a cross sectional view showing a structure after cleaning the semiconductor device shown in Fig. 9 by using the cleaning agent for the semiconductor device according to the present invention in Example 4.

In the figures, the reference signs are as follows:
1 CVD oxide layer
2 TiW layer
3 CVD-W layer
4 Al-Si-Cu layer
5 TiN layer
6 PLASMA TEOS layer
7 photoresist
8 side wall protecting deposition film
9 CVD oxide layer
10 Ti layer
11 TiN layer
12 W (tungsten) layer
13 photoresist
14 side wall protecting deposition film

### DESCRIPTION OF THE PREFERRED EMBODIMENT

The quaternary ammonium salt used in the present invention is represented by the following formula:

[(R₁)₃N-R]⁺ · X⁻

in which R represents an alkyl group of 1 to 4 carbon atoms or a hydroxyl substituted alkyl group of 1 to 4 carbon atoms, R₁ represents an alkyl group of 1 to 4 carbon atoms and X represents an organic acid group or inorganic acid group.

Examples of the quaternary ammonium salt represented by the foregoing general formula include tetramethylammonium formate, tetramethylammonium acetate, tetramethylammonium propionate, tetramethylammonium butyrate, tetramethylammonium oxalate, tetramethylammonium malonate, tetramethylammonium maleate, tetramethylammonium fumarate, tetramethylammonium citraconate, tetramethylammonium benzoate, tetramethylammonium toluate, tetramethylammonium phthalate, tetramethylammonium acrylate, trimethyl(2-hydroxyethyl)ammonium formate, trimethyl(2-hydroxyethyl)ammonium acetate, trimethyl(2-hydroxyethyl)ammonium benzoate, trimethyl(2-hydroxyethyl)ammonium phthalate, tetraethylammonium formate, tetraethylammonium acetate, tetrapropylammonium formate, tetrapropylammonium acetate, tetrabutylammonium formate, tetrabutylammonium acetate, tetramethylammonium borate, tetramethylammonium phosphate, tetramethylammonium sulfate, trimethyl(2-hydroxyethyl)ammonium borate, trimethyl(2-hydroxyethyl)ammonium phosphate and trimethyl(2-hydroxyethyl)ammonium sulfate.

The concentration of the quaternary ammonium salt in the cleaning agent for the semiconductor device according to the present invention is within a range from 1 to 60%, preferably, 10 to 50% by weight. If the concentration of the quaternary ammonium salt is less than 1% by weight, violent corrosion undesirably occurs to the wiring material, whereas if it is more than 60% by weight, the removing rate for the side wall protecting deposition film is unfavorably lowered.

As the fluoro-compound in the cleaning agent for the semiconductor device according to the present invention, a compound is selected from the group consisting of hydrofluoric acid, ammonium fluoride, ammonium hydrogen fluoride, ammonium borofluoride, tetramethylammonium fluoride and tetramethylammonium hydrogen fluoride.

The concentration of the fluoro-compound is from 0.1 to 10, preferably, 0.5 to 5% by weight. If the concentration of the fluoro-compound is less than 0.1% by weight, the removing rate for the side wall protecting deposition film is lowered, whereas violent corrosion occurs to the wiring material at a concentration higher than 10% by weight.

As the organic solvent to be further added in the present invention, there are mentioned an amide such as dimethylformamide, dimethylacetamide, formamide and N-methylpyrrolidone, a lactone such as γ-butyrolactone, a nitrile such as acetonitrile and benzonitrile, an alcohol such as methanol, ethanol, isopropanol and ethylene glycol and an ester such as methyl acetate, ethyl acetate and methyl benzoate.

The concentration of the organic solvent is from 1 to 60%, preferably, 20 to 55% by weight. If the concentration of the organic solvent is less than 1% by weight, violent corrosion occurs to the wiring material, whereas the removing rate for the side wall protecting deposition film is lowered at a concentration higher than 60% by weight.

The temperature of the cleaning agent for the semiconductor device according to the present invention upon removing the side wall protecting deposition film is usually ordinary temperature, for example, 18 to 25°C. If the removing rate for the side wall protecting deposition film is remarkably low, it is used being heated, for example, to 25 to 60°C. Further, the cleaning temperature and the cleaning time are properly selected considering the state of the side wall protecting deposition film and the kind of the wiring materials.

Upon peeling of the side wall protecting deposition film by cleaning, the peeling step is put into practice by applying the cleaning agent according to the present invention to a conventional method in which the semiconductor substrate to be processed is subjected, for example, to dipping cleaning by batch-wise system or to spray cleaning for each substrate, followed by cleaning with purified water and drying to complete the objective peeling process.

The cleaning agent for the semiconductor device according to the present invention is used in the process for manufacturing the semiconductor device for the purpose of removing a protecting deposition film formed on the side walls of the conductive layer and the photoresist when a wiring structure by dry etching is formed after forming a mask with the photoresist for the conductive layer formed on the semiconductor substrate with a positive or negative type single-layer photoresist or a multilayer photoresist. Since the protecting deposition film can be peeled highly reliably by using the above-mentioned cleaning agent, the surface of the conductive layer is decontaminated and cleaned, so that no corrosion occurs.

Further, the cleaning agent for the semiconductor device according to the present invention is applicable also to the removal of the protecting deposition film formed upon dry etching of a titanium or tungsten layer which has heretofore been difficult to remove and thus making itself effectively usable in the manufacture of a semiconductor device or highly integrated circuit of a multilayer structure.

In addition, mention will be made of the following advantages in using the cleaning agent for the semiconductor device according to the present invention.
(1) Protecting deposition film formed on the side walls of the conductive film and the photoresist which has heretofore been difficult to remove can certainly be peeled in a short period of time at about ordinary temperature.
(2) An aluminum alloy or the like as a wiring material does not undergo etching in using the present cleaning agent.
(3) Since water is usable for rinsing after using the present cleaning agent, the rinsing operation is extremely facilitated.

In the following, the present invention will now be explained more specifically with reference to non-limitative examples along with comparative Examples.

### Example 1

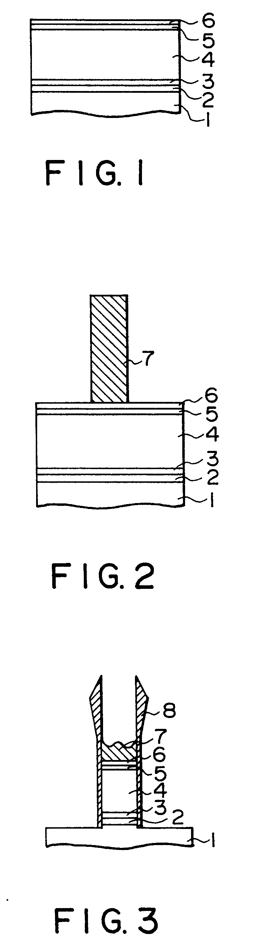

When a mask was formed with a photoresist to a semiconductor device immediately after forming a conductive layer of a structure shown in Fig. 1 and a wiring structure was formed by dry etching, a side wall protecting deposition film formed on the side walls of the conductive layer and the photoresist was cleaned.

In the semiconductor device immediately after forming a conductive layer shown in Fig. 1, there were successively formed, on a CVD oxide layer 1 as an intermediate insulation film, a TiW layer 2 as a first metal film layer; a CVD-W layer 3 as a second metal film layer; an Al-Si-Cu layer 4 as a third metal film layer; a TiN layer 5 as anti-reflection film; and a PLASMA TEOS layer 6 as a chemical resistant protecting film. Each of the metal films has a thickness of 60 nm for the first metal film layer 2, 50 nm for the second metal film layer 3, 500 nm for the third metal film layer 4, 20 nm for the TiN layer 5 as the upper film layer and 40 nm for the PLASMA TEOS film 6. The Al-Si-Cu layer 4 contained 1% by wt% of Si and 0.5% by weight of Cu.

Fig. 2 shows a structure upon completion up as far as a mask forming process. A positive type photoresist 7 was applied to the conductive layer shown in Fig. 1 and then exposed to form a resist mask portion. The photoresist 7 used therein was a multilayer resist composed mainly of a novolac resin.

Fig. 3 shows a structure after removing a region of the conductive layer not covered with the photo-mask (nonmasked region) by means of dry etching using a chloro-gas. Formation of the side wall protecting deposition film 8 was already observed on the side of the patterned conductive layer.

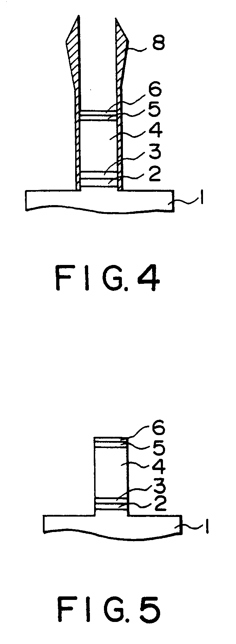

Fig. 4 shows a structure after removing the masking resist by ashing followed by cleaning with an organic solvent after dry etching. It was confirmed that removal of the side wall protecting deposition film 8 was difficult by this method.

Fig. 5 shows the structure after cleaning the semiconductor device shown in Fig. 4 by using a cleaning agent for the semiconductor device according to the present invention. A solution of ammonium fluoride/tetramethylammonium formate/dimethylformamide/water at 1/10/40/49(wt% ratio) was used as the cleaning agent for the semiconductor device and cleaning was carried out at 23°C for 20 min, followed by water washing.

It can be seen from Fig. 5 that the side wall protecting deposition film 8 in Fig. 4 is completely removed by using the cleaning agent for the semiconductor device according to the present invention, so that the surface of the patterned conductive layer is decontaminated and cleaned.

### Example 2

The same semiconductor device as that in Fig. 4 for Example 1 was cleaned by using a cleaning solution having a composition consisting of ammonium fluoride/tetramethylammonium formate/water at 2/45/53 (wt% ratio) at 23°C for 20 min and then washed with water. As a result, the side wall protecting deposition film was completely removed in the same manner as in Example 1, so that the surface of the patterned conductive layer was decontaminated and cleaned.

### Example 3

The same semiconductor device as that in Fig. 4 for Example 1 was cleaned by using a cleaning solution having a composition consisting of tetramethylammonium fluoride/tetramethylammonium acetate/dimethylacetoamide/water at 5/15/40/40 (wt% ratio) at 25°C for 30 min and then washed with water. As a result, the side wall protecting deposition film was completely removed in same manner as in Example 1, so that the surface of the patterned conductive layer was decontaminated and cleaned.

### Comparative Example 1

The same semiconductor device as that in Fig. 4 for Example 1 was cleaned by using a commercially available cleaning solution (alkaline resist cleaning solution) at 100°C for 10 min as the cleaning conditions. As a result, the side wall protecting deposition film could not be removed.

### Comparative Example 2

The same semiconductor device as that in Fig. 4 for Example 1 was cleaned by using a 1% by weight aqueous solution of ammonium fluoride at 23°C for 20 min. As a result, it was observed that although the side wall protecting deposition film could be removed, violent corrosion resulted in the Al-Si-Cu layer.

### Example 4

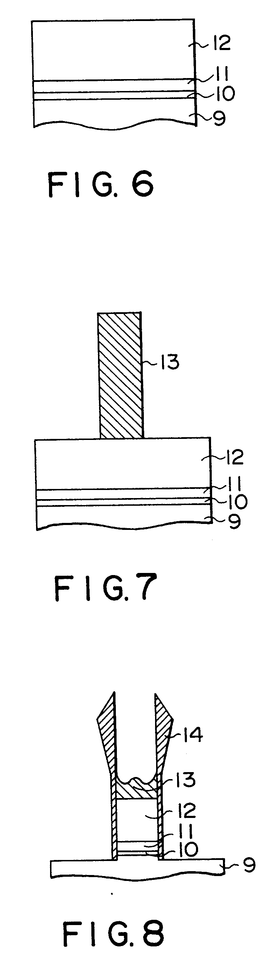

When a mask was formed with a photoresist to a semiconductor device immediately after forming a conductive layer of a structure shown in Fig. 6 and wiring structure was formed by dry etching, side wall protecting deposition film formed on the side walls of the conductive layer and the photoresist was cleaned.

In the semiconductor device immediately after forming the conductive layer in Fig. 6, there were successively formed, on a CVD oxide film 9 as an intermediate insulation film, a Ti layer 10 as a first metal film layer; a TiN layer 11 as a second metal film layer; and a W (tungsten) layer 12 as a third metal film layer.

The film thickness for each of the metal films was 30 to 50 nm for the first metal film layer 10, 50 to 70 nm for the second metal film layer 11 and 300 nm for the third metal film layer 12.

Fig. 7 shows a structure upon completion up as far as mask forming step. A positive type photoresist 13 was applied to the conductive layer shown in Fig. 6 and then exposed to form a resist mask portion. The photoresist 13 used therein was a multilayer resist composed mainly of a novolac resin.

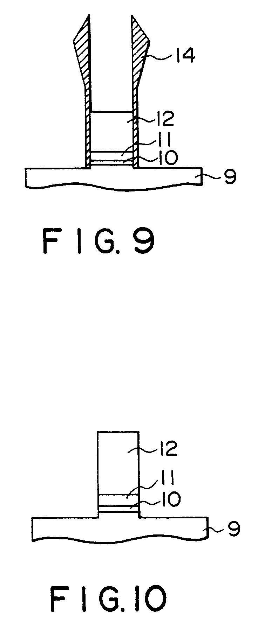

Fig. 8 shows a structure after removing a region of the conductive layer not covered with the photo-mask (nonmasked region) by means of dry etching. Formation of the side wall protecting deposition film 14 was already observed on the side of the patterned conductive layer.

Fig. 9 shows the structure after removing the masking resist by ashing, after dry etching. It was confirmed that although the removal was possible up as far as the resist but the removal of the side wall protecting deposition film 14 was difficult by this method.

Fig. 10 shows a structure after cleaning the semiconductor device in Fig. 9 by using a cleaning agent for the semiconductor device according to the present invention. An aqueous solution of ammonium fluoride/tetramethylammonium formate/dimethylformamide/water at 1/10/40/49 (wt% ratio) was used as the cleaning agent for the semiconductor device and cleaning was carried out at 23°C for 20 min, followed by water washing and drying. It can be seen in Fig. 10 that the side wall protecting deposition film 14 is removed and the surface of the patterned conductive layer is decontaminated and cleaned.

### Example 5

The same semiconductor device as that in Fig. 9 for Example 4 was cleaned by using a cleaning solution having a composition consisting of ammonium fluoride/tetramethylammonium formate/water at 2/45/53 (wt% ratio) at 23°C for 20 min and then washed with water. As a result, the side wall protecting deposition film 14 was completely removed in same manner as in Example 4, so that the surface of the patterned conductive layer was decontaminated and cleaned.

### Example 6

The same semiconductor device as that in Fig. 9 for Example 4 was cleaned by using a cleaning solution having a composition consisting of ammonium fluoride/trimethyl(2-hydroxyethyl)ammonium formate/dimethylformamide/water at 2/20/30/48 (wt% ratio) at 25°C for 20 min and then washed with water. As a result, the side wall protecting deposition film 14 was completely removed in same manner as in Example 4, so that the surface of the patterned conductive layer was decontaminated and cleaned.

### Comparative Example 3

The same semiconductor device as that in Fig. 9 for Example 4 was cleaned by using a commercially available cleaning solution (alkaline resist cleaning solution) at 100°C for 20 min as the cleaning conditions. As a result, the side wall protecting deposition film 14 could not be removed.

### Comparative Example 4

The same semiconductor device as that in Fig. 9 for Example 4 was cleaned by using a cleaning solution having a composition consisting of tetramethylammonium formate/dimethylformamide/water at 10/40/50 (wt% ratio) at 25°C for 30 min as the cleaning conditions, followed by water washing. As a result, the side wall protecting deposition film 14 could not be removed.

## Claims

1. A cleaning agent for peeling a protecting deposition film in a process for manufacturing a semiconductor device which comprises a quaternary ammonium salt represented by the general formula:
[(R₁)₃N-R]⁺ · X⁻
in which R represents an alkyl group of 1 to 4 carbon atoms or a hydroxyl-substituted alkyl group of 1 to 4 carbon atoms, R₁ represents an alkyl group of 1 to 4 carbon atoms and X represents an organic acid group or inorganic acid group; and a fluoro-compound selected from the group consisting of hydrofluoric acid, ammonium fluoride, ammonium hydrogen fluoride, ammonium borofluoride, tetramethylammonium fluoride and tetramethylammonium hydrogen fluoride, wherein the concentration of said quaternary ammonium salt in said cleaning agent is within a range of 1 to 60 % by weight and wherein the concentration of said fluoro-compound in said cleaning agent is within a range of 0.1 to 10 % by weight.

2. The cleaning agent according to Claim 1 which further comprises 1 to 60 % by weight of at least one organic solvent selected from the group consisting of amides, lactones, nitriles, alcohols and esters.

3. The cleaning agent according to Claim 2 wherein the amide is selected from dimethylformamide, dimethylacetamide, formamide and N-methylpyrrolidone; the lactone is selected from γ-butyrolactone; the nitrile is selected from acetonitrile and benzonitrile; the alcohol is selected from methanol, ethanol, isopropanol and ethylene glycol; and the ester is selected from methyl acetate, ethyl acetate and methyl benzoate.

4. The cleaning agent according to Claim 2 wherein the concentration of said organic solvent in said cleaning agent is within the range of 20 to 55 % by weight.

5. A method of manufacturing a semiconductor device by forming a mask with a photoresist on a conductive layer formed on a semiconductor substrate and containing at least one of titanium, tungsten, and aluminum alloy and then forming a wiring structure by dry etching and removing the photoresist by ashing which method comprises a cleaning step of peeling a protecting deposition film formed on side walls of both the conductive layer and the photoresist during the dry etching step by using a cleaning agent as defined in Claim 1.

6. The method according to Claim 5 wherein the cleaning agent further comprises 1 to 50 % by weight of at least one organic solvent selected from the group consisting of amides, lactones, nitriles, alcohols and esters.

## Patentansprüche

1. Reinigungsmittel zum Abziehen eines schützenden Ablagerungsfilms in einem Verfahren zur Herstellung einer Halbleiter-Anordnung, welches ein quaternäres Ammoniumsalz umfaßt, das durch die allgemeine Formel:
[(R₁)₃N-R]⁺ · X⁻
dargestellt wird, wobei R eine Alkylgruppe mit 1 bis 4 Kohlenstoffatomen oder eine Hydroxyl-substituierte Alkylgruppe mit 1 bis 4 Kohlenstoffatomen darstellt, R₁ eine Alkylgruppe mit 1 bis 4 Kohlenstoffatomen darstellt und X eine organische Säuregruppe oder anorganische Säuregruppe darstellt; und eine Fluorverbindung, ausgewählt aus der aus Fluorwasserstoffsäure, Ammoniumfluorid, Ammoniumhydrogenfluorid, Ammoniumborofluorid, Tetramethylammoniumfluorid und Tetramethylammoniumhydrogenfluorid bestehenden Gruppe, wobei die Konzentration des quaternären Salzes im Reinigungsmittel in einem Bereich von 1 bis 60 Gew.-% liegt und wobei die Konzentration der Fluoroverbindung im Reinigungsmittel in einem Bereich von 0,1 bis 10 Gew-% liegt.

2. Reinigungsmittel nach Anspruch 1, welches darüber hinaus 1 bis 60 Gew.-% mindestens eines organischen Lösungsmittels umfaßt, ausgewält aus der aus Amiden, Lactonen, Nitrilen, Alkoholen und Estern bestehenden Gruppe.

3. Reinigungsmittel nach Anspruch 2, wobei das Amid ausgewählt wird aus Dimethylformamid, Dimethylacetamid, Formamid und N-Methylpyrrolidon; das Lacton ausgewählt wird aus γ-Butyrolacton; das Nitril ausgewählt wird aus Acetonitril und Benzonitril; der Alkohol ausgewählt wird aus Methanol, Ethanol, Isopropanol und Ethylenglykol; und der Ester ausgewählt wird aus Methylacetat, Ethylacetat und Methylbenzoat.

4. Reinigungsmittel nach Anspruch 2, wobei die Konzentration des organischen Lösungsmittels im Reinigungsmittel im Bereich von 20 bis 55 Gew.-% liegt.

5. Verfahren zur Herstellung einer Halbleiter-Anordnung durch Bilden einer Maske mit einem Photoresist auf einer leitenden Schicht, die auf einem Halbleiter-Substrat ausgebildet ist und mindestens eines von Titan, Wolfram und Aluminiumlegierung enthält, und dann Ausbilden einer Verdrahtungsstruktur durch Trockenätzen und Entfernen des Photoresists durch Veraschen, wobei das Verfahren einen Reinigungsachritt des Abziehens einer schützenden Ablagerungsschicht, die auf den Seitenwänden sowohl der leitenden Schicht als auch des Photoresists ausgebildet ist, während des Trockenätzens durch Verwendung eines wie in Anspruch 1 definierten Reinigungsmittels umfaßt.

6. Verfahren nach Anspruch 5, wobei das Reinigungsmittel darüber hinaus 1 bis 50 Gew.-% mindestens eines Lösungsmittel umfaßt, ausgewählt aus der aus Amiden, Lactonen, Nitrilen, Alkoholen und Estern bestehenden Gruppe.

## Revendications

1. Agent de nettoyage pour enlever un film de dépôt protecteur dans un procédé de fabrication d'un dispositif semiconducteur qui comprend un sel d'ammonium quaternaire représenté par la formule générale :
[(R₁)₃N-R]⁺.X⁻
dans laquelle R représente un groupe alkyle comportant 1 à 4 atomes de carbone ou un groupe alkyle à substituant hydroxyle comportant 1 à 4 atomes de carbone, R¹ représente un groupe alkyle comportant 1 à 4 atomes de carbone et X représente un groupe acide organique ou un groupe acide inorganique ; et un composé fluoré choisi dans le groupe comprenant l'acide fluorhydrique, le fluorure d'ammonium, l'hydrogénoflurorure d'ammonium, le borofluorure d'ammonium, le fluorure de tétraméthylammonium et l'hydrogénofluorure de tétraméthylammonium, dans lequel la concentration dudit sel d'ammonium quaternaire dans ledit agent de nettoyage se situe dans l'intervalle de 1 à 60 % en poids et dans lequel la concentration dudit composé fluoré dans ledit agent de nettoyage se situe dans l'intervalle de 0,1 à 10 % en poids.

2. Agent de nettoyage selon la revendication 1, qui comprend en outre 1 à 60 % en poids d'au moins un solvant organique choisi dans le groupe comprenant des amides, des lactones, des nitriles, des alcools et des esters.

3. Agent de nettoyage selon la revendication 2, dans lequel l'amide est choisi parmi le diméthyhformamide, le diméthylacétamide, le formamide et la N-méthylpyrrolidone ; la lactone est choisie parmi la γ-butyrolactone ; le nitrile est choisi parmi l'acétonitrile et le benzonitrile ; l'alcool est choisi parmi le méthanol, l'éthanol, l'isopropanol et l'éthylèneglycol ; et l'ester est choisi parmi l'acétate de méthyle, l'acétate d'éthyle et le benzoate de méthyle.

4. Agent de nettoyage selon la revendication 2, dans lequel la concentration dudit solvant organique dans ledit agent de nettoyage se situe dans l'intervalle de 20 à 55 % en poids.

5. Procédé de fabrication d'un dispositif semiconducteur qui consiste à former un masque avec une photoréserve sur une couche conductrice formée sur un substrat semiconducteur et contenant au moins un élément parmi le titane, le tungstène et un alliage d'aluminium et ensuite à former une structure de câblage par attaque à sec et à éliminer la photoréserve par incinération, lequel procédé comprend une étape de nettoyage d'enlèvement d'un film de dépôt protecteur formé sur les parois latérales à la fois de la couche conductrice et de la photoréserve au cours de l'étape d'attaque à sec grâce à l'utilisation d'un agent de nettoyage tel que défini dans la revendication 1.

6. Procédé selon la revendication 5, dans lequel l'agent de nettoyage comprend en outre 1 à 50 % en poids d'au moins un solvant organique choisi dans le groupe comprenant des amides, des lactones, des nitriles, des alcools et des esters.
